Europäisches Patentamt

European Patent Office

Office européen des brevets

(11) Publication number: **0 168 535**
**B1**

(12) **EUROPEAN PATENT SPECIFICATION**

(45) Date of publication of patent specification: **10.10.90**

(21) Application number: **84304819.0**

(22) Date of filing: **16.07.84**

(51) Int. Cl.⁵: **H 05 K 3/06,** H 05 K 3/10, H 05 K 3/46, H 01 L 21/90, H 01 L 23/52

(54) A method of producing a layered structure.

(43) Date of publication of application:
**22.01.86 Bulletin 86/04**

(45) Publication of the grant of the patent:
**10.10.90 Bulletin 90/41**

(84) Designated Contracting States:
**AT BE CH DE FR IT LI LU NL SE**

(56) References cited:
**EP-A-0 043 458**
**DE-B-2 334 213**
**FR-A-2 357 071**

(73) Proprietor: **PLESSEY OVERSEAS LIMITED**
**Vicarage Lane**
**Ilford Essex IG1 4AQ (GB)**

(72) Inventor: **Rhodes, Stephen James**
**29 Hertford Court**
**Northampton (GB)**

(74) Representative: **Lupton, Frederick et al**
**The Plessey Company plc Intellectual Property Dept. Vicarage Lane**
**Ilford, Essex IG1 4AQ (GB)**

Courier Press, Leamington Spa, England.

**Description**

This invention relates to a method of producing a layered structure, which layered structure is used for forming electrical interconnections in an integrated circuit.

Integrated circuits require the formation of layered structures comprising various levels of metal defining between them vias, that is metal to metal connections through apertures in intermediate insulating layers.

There are three factors which determine how the metal layers at each level are to be defined, i.e. metal to metal spacing $(m)$; Via size $(v)$; and, metal surround width around the via $(s)$.

Normally, there are two considerations which require that the via be surrounded by metal both on first level metallisation and second level metallisation. Firstly, if the via is not contained within the first level metallisation, a gap is generally formed around the first level metal causing difficulties with second level metal step coverage within the via. These difficulties can result in excessive reductions in metal thickness in the connection between first and second level metal causing premature failure of the structure in use. Secondly, if the via surround is eliminated, problems can arise when, due to alignment tolerances, the second level metallisation does not completely cover the via. When this occurs, the first level metal is exposed in the via and may be etched during the etch process used to define the second level metal, resulting in excessive reductions in the thickness of the first level metal which may also cause premature failure of the structure in use.

FR-A-2357071 discloses a process for overcoming problems of forming metal contacts in apertures in integrated circuits, the process comprising forming first electrically conductive regions in the apertures and then subsequently forming a second electrically conductive layer which contracts the first electrically conductive regions. This process overcomes problems of cracks in the metal around the edges of deep apertures.

In an effort to overcome this problem, the present invention provides a method for producing a layered structure comprising first and second levels of metallisation interconnected by one or more vias, the method comprising forming the first level of metallisation by depositing a parting layer on a spacer layer, etching the parting layer and the spacer layer to delineate field regions therein, depositing a first metal layer, dissolving the parting layer to remove the first metal layer in the field regions and to leave the first metal layer in one or more via regions, depositing a dielectric layer, exposing the first metal layer through the dielectric layer, depositing a second metal layer and etching the second matal layer to form the second level of metallisation, characterised in that an etch barrier layer is deposited on the first metal layer prior to said step of dissolving the parting layer to form the first level of metallisation.

The lift-off procedure for forming the first level metallisation may be such that the majority of an insulating spacer layer is left remaining and such that the first level metal is provided by magnetron sputtering. This may provide a much improved connection between the first and second metal layers. Delineation problems associated with etching composite metal layers are avoided by the use of the lift-off method.

Preferably, the method of the present invention is characterised by, after dissolving the parting layer, depositing a passivation layer, depositing a dielectric layer on the passivation layer, exposing the etch barrier layer through the passivation layer and the dielectric layer, depositing a second metal layer, and etching the second metal layer to form the second level of metallisation.

Preferably, the metal layers are deposited by magnetron sputtering.

The parting layer and the spacer layer may be etched by plasma etching.

Preferably, the plasma etching comprises oxygen plasma etching.

An embodiment of the invention will now be described solely by way of example and with reference to the accompanying drawings in which:-

Figure 1 illustrates a nested via and is for use in illustrating metallisation layout rules;

Figure 2 illustrates a non-nested via and is for use in illustrating metallisation layout rules;

Figure 3 illustrates the problems which can arise with second metal deposition if a via is not contained within the first level metallisation; and,

Figure 4 illustrates a method of forming a via according to the present invention.

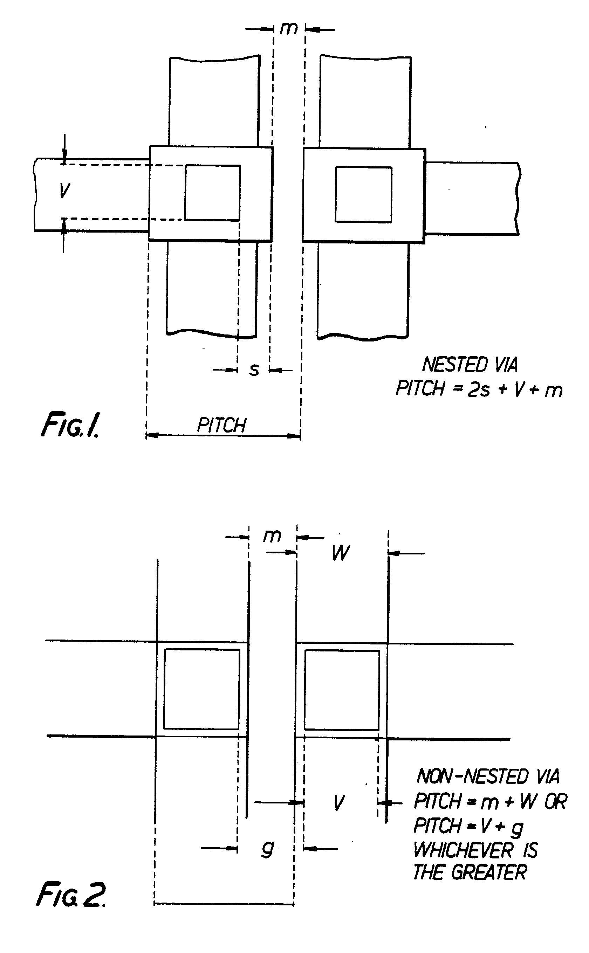

Referring to Figures 1 and 2, there is illustrated, for nested and non-nested vias, the metal to metal spacing $(m)$, the via size $(v)$, the metal surround around the via $(s)$, the minimum metal width $(w)$, and the via to via gap $(g)$. For the nested via illustrated in Figure 1, the metal pitch, which relates to the overall packing density, in an integrated circuit is equal to $m + v + 2s$. In the non-nested via illustrated in Figure 2, the metal pitch equals $m + w$ or $v + g$, whichever is the greater.

It can be seen by comparing Figures 1 and 2 that the via pitch with non-nested vias is smaller than that of nested vias. However, due to alignment tolerances present in current methods of forming vias, non-nested vias are more likely to give rise to defects in the resulting layered structure, as previously described.

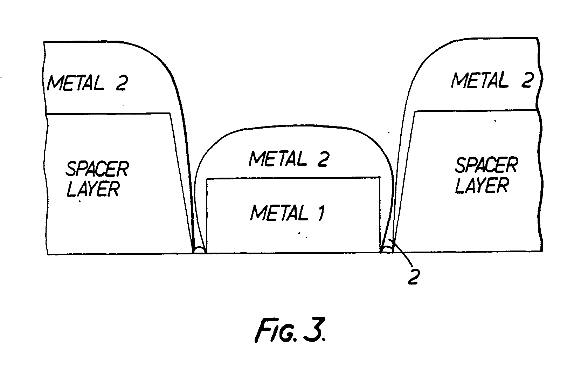

Figure 3 shows the problem which can arise if the via is not contained within the first level metallisation. A gap 2 is formed around the first level metal which produces a steep sided and deep via in which it is extremely difficult to deposit the second metal layer. Often, the second metal layer contains portions having excessive reductions in metal thickness and micro-cracks.

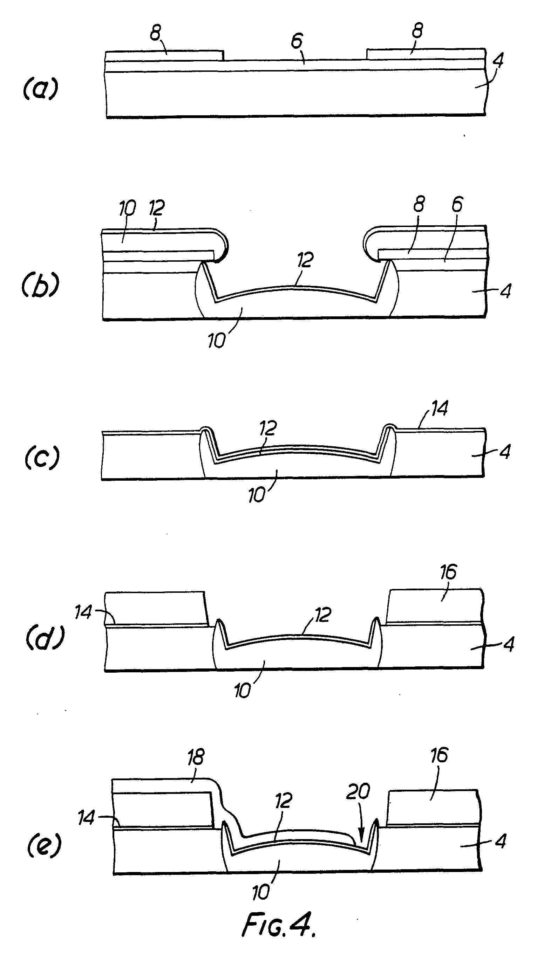

Referring now to Figure 4, this Figure has been divided into five parts, namely Figures 4a, b, c, d, and e.

Referring to Figure 4a, it will be seen that a polyimide is coated and imidised onto a suitable substrate such as silicon to provide a spacer layer 4 for the first metal lift-off. A thin organic film in the form of a photo-resist film is spun onto the spacer layer 4 to act as a parting layer 6 for the lift-off procedure. An aluminium masking layer 8 is then deposited on the parting layer 6 and the field regions of the first layer metal, that is regions where it is desired to remove metal in the first layer metal, are delineated in this masking layer 8 such that the masking layer 8 is etched where the first layer metal is required, to form a masking pattern.

Referring to Figure 4b, the parting layer 6 and the spacer layer 4 are etched through the masking pattern in the masking layer 8 using an oxygen plasma etch to form a via in the spacer layer 4. The first layer metal 10 is now deposited by magnetron sputtering. The first layer metal is essentially pure of doped aluminium but it is covered with a thin layer of chromium to produce an etch barrier layer 12. It can be seen from Figure 4b that at this stage of the process, the via contains a layer of the first metal 10 capped by the etch barrier layer 12.

Referring now to Figure 4c, a lift-off is executed to produce the first level of metallisation by dissolving the parting layer 6 in a suitable solvent, thus floating off the masking layer 8 and the first layer metal 10 and the etch barrier layer 12 over the field regions, exposing the surface of the spacer layer 4. A thin silicon passivation layer 14 may now be deposited over the spacer layer 4 and the remaining first layer metal 10 and etch barrier layer 12. The passivation layer 14 acts to protect the spacer layer 6 during subsequent stages of the process. The passivation layer 14 may be 25A thick and it may be of another material such as for example titanium.

A dielectric layer 16 is now deposited on the passivation layer 14 and imidised. The dielectric layer 16 may comprise any suitable insulating material such as polyimide. When the dielectric layer is imidised the silicon passivation layer normally converts to silicon oxide. A masking pattern is then formed on the dielectric layer 16 and the dielectric layer 16 and the underlying passivation layer 14 are etched in accordance with the masking pattern to expose the etch barrier layer 12 in the via through the passivation layer 14 and the dielectric layer 16. The passivation layer 14 can be removed from within the via either by wet etching or back sputtering. This produces the structure shown in Figure 4d of the accompanying drawings.

A layer of second level metal 18 is now deposited over the structure shown in Figure 4d, with the interconnection between the second level metal 18 and the first level metal 10 being made in the via by means of the chromium etch barrier layer 12, as shown in Figure 4e.

A masking pattern is then formed over the second level metal 18 and the second level metal is etched through the masking pattern to remove unwanted metal in the field regions of the second level metallisation. The purpose of the chrome etch barrier layer 12 will now become clear. Due to alignment tolerances, the masking pattern used to enable selective etching of the second level metal 18 may not be aligned exactly with the via. If this misalignment occurs in the process, the second level metal 18, when etched, will be shown in Figure 4e.

The presence of the etch barrier layer 12 prevents the first level metal 10 being etched in the region 20 and hence, the excessive reductions in thickness of the first level metal, experienced with existing methods, do not occur.

The method of the invention provides a reliable method of achieving high density multi level metallisation by using non-nested vias. No factor for via surround is incorporated in the equation for metallisation pitch, thereby achieving a significant improvement in metallisation packing density.

The method also incorporates a solution to first level metal attack and via step coverage problems that are usually encountered when fabricating non-nested vias with current processing methods.

The method of the invention is particularly applicable to the provision of oxide isolated $1^2L$ integrated circuits where, with current techniques, metallisation packing density is limiting circuit density. It is to be appreciated however that the invention can also be used in most double level metallisation applications with similar benefits. The method of the invention can also be used for more than two levels of metal.

It is to be appreciated that the embodiment of the invention described above with reference to the accompanying drawings has been given by way of example alone in that modifications may be effected. Thus, for example, the masking layer 8 may be of a metal other than aluminium and the plasma etching of the parting layer 6 and the spacer layer 4 may be by a plasma etching other than oxygen plasma etching. The first layer metal is preferably aluminium or doped aluminium but other metals may be employed. Also, the first layer metal is preferably capped with chromium but again other metals may be employed.

## Claims

1. A method for producing a layered structure comprising first and second levels of metallisation interconnected by one or more vias the method comprising forming the first level of metallisation by depositing a parting layer (6) on a spacer layer (4), etching the parting layer (6) and the spacer layer (4) to delineate field regions therein, depositing a first metal layer (10), dissolving the parting layer (6) to remove the first metal layer (10) in the field regions and to leave the first metal layer in one or more via regions, depositing a dielectric layer (16), exposing the first metal layer (10) through the dielectric layer (16), depositing a second metal layer (18) and etching the second metal layer (18) to form the second level of metallisation, characterised in that an etch barrier layer (12) is deposited on the first metal layer (10) prior to said step of dissolving the parting layer (6) to form the first level of metallisation.

2. A method according to claim 1, characterised by depositing onto the spacer layer (4) a passivation layer (14) intermediate said step of dissolving the parting layer (6) and said step of depositing a dielectric layer (16).

3. A method according to claim 1 or 2 characterised in that the parting layer (6) and the spacer layer (4) are etched by plasma etching.

4. A method according to claim 3 characterised in that the plasma etching is oxygen plasma etching.

5. A method according to any one of the preceding claims characterised in that the parting layer (6) is deposited by spinning.

6. A method according to any one of claims 2 to 5 characterised in that the first and second metal layers (10, 18) are deposited by magnetron sputtering.

7. A method according to any one of claims 2 to 6 characterised in that the etch barrier layer (12) is exposed by etching the dielectric layer (16) and back sputtering the passivation layer (14).

8. A method according to any one of claims 2 to 6 characterised in that the etch barrier layer (12) is exposed by etching the dielectric layer (16) and the passivation layer (14).

9. A method according to any one of the preceding claims characterised in that the parting layer (6) and the spacer layer (4) are etched through an aluminium masking layer (8) having the field regions delineated therein.

10. A method according to any one of the preceding claims characterised in that the parting layer (6) comprises photo resist.

11. A method according to any one of the preceding claims characterised in that the spacer layer (4) comprises polyimide.

12. A method according to any one of the preceding claims characterised in that the etch barrier layer (12) comprises chromium.

13. A method according to any one of claims 2 to 12 characterised in that the dielectric layer (16) comprises polyimide.

14. A method according to any one of claims 2 to 13 characterised in that the passivation layer (14) comprises titanium.

15. A method according to any one of claims 2 to 13 characterised in that the passivation layer (14) comprises silicon.

**Patentansprüche**

1. Verfahren zum Herstellen einer geschichteten Struktur mit ersten und zweiten Metallisierungsniveaus, untereinander verbunden durch einen oder mehrere Durchgänge, umfassend: Erzeugen des ersten Metallisierungsniveaus mittels Ablagerung einer Trennschicht (6) auf einer Distanzschicht (4); Aetzen der Trennschicht (6) und der Distanzschicht (4), um Feldbereiche darin festzulegen; Ablagern einer ersten Metallschicht (10); Herauslösen der Trennschicht (6), um die erste Metallschicht (10) in den Feldbereichen zu entfernen und um die erste Metallschicht in einem oder mehrerer Durchgangsbereiche zu belassen; Ablagern einer dielektrischen Schicht (16); Freilegen der ersten Metallschicht (10) durch die dielektrische Schicht (16) hindurch; Ablagern einer zweiten Metallschicht (18) und Aetzen der zweiten Metallschicht (18), um das zweite Metallisierungsniveau zu erzeugen, dadurch gekennzeichnet, dass eine Aetzsperrschicht (12) auf der ersten Metallschicht (10) abgelagert wird vor dem besagten Schritt des Herauslösens der Trennschicht (6), um das erste Metallisierungsniveau zu erzeugen.

2. Verfahren nach Anspruch 1, dadurch gekennzeichnet, dass auf der Distanzschicht (4) eine Passivierungsschicht (14) zwischen dem besagten Schritt des Herauslösens der Trennschicht (6) und dem besagten Schritt des Ablagerns einer dielektrischen Schicht (16) abgelagert wird.

3. Verfahren nach einem der Ansprüche 1 oder 2, dadurch gekennzeichnet, dass die Trennschicht (6) und die Distanzschicht (4) mittels Plasmaätzen geätzt werden.

4. Verfahren nach Anspruch 3, dadurch gekennzeichnet, dass die Plasmaätzung eine Sauerstoffplasmaätzung ist.

5. Verfahren nach irgendeinem der vorangehenden Ansprüche, dadurch gekennzeichnet, dass die Trennschicht (6) mittels Spinnablagerung erzeugt wird.

6. Verfahren nach irgendeinem der Ansprüche 2 bis 5, dadurch gekennzeichnet, dass die erste und zweite Metallschicht (10, 18) mittels Magnetronzerstäubung abgelagert werden.

7. Verfahren nach irgendeinem der Ansprüche 2 bis 6, dadurch gekennzeichnet, dass die Aetzsperrschicht (12) durch Aetzen der dieleketrischen Schicht (16) und durch Rückstäubung der Passivierungsschicht (14) freigelegt wird.

8. Verfahren nach irgendeinem der Ansprüche 2 bis 6, dadurch gekennzeichnet, dass die Aetzsperrschicht (12) durch Aetzen der dielektrischen Schicht (16) und der Passivierungsschicht (14) freigelegt wird.

9. Verfahren nach irgendeinem der vorangehenden Ansprüche, dadurch gekennzeichnet, dass die Trennschicht (6) und die Distanzschicht (4) durch eine Aluminiummaskierschicht (8) geätzt werden, in welcher die Feldbereiche festgelegt sind.

10. Verfahren nach irgendeinem der vorangehenden Ansprüche, dadurch gekennzeichnet, dass die Trennschicht (6) ein photoresistentes Material enthält.

11. Verfahren nach irgendeinem der vorangehenden Ansprüche, dadurch gekennzeichnet, dass die Distanzschicht (4) Polyimid enthält.

12. Verfahren nach irgendeinem der vorangehenden Ansprüche, dadurch gekennzeichnet, dass die Aetzsperrschicht (12) Chrom enthält.

13. Verfahren nach irgendeinem der Ansprüche 2 bis 12, dadurch gekennzeichnet, dass die dielektrische Schicht (16) Polyimid enthält.

14. Verfahren nach irgendeinem der Ansprüche 2 bis 13, dadurch gekennzeichnet, dass die Passivierungsschicht (14) Titan enthält.

15. Verfahren nach irgendeinem der Ansprüche 2 bis 13, dadurch gekennzeichnet, dass die Passivierungsschicht (14) Silikon enthält.

**Revendications**

1. Procédé pour produire une structure multicouche, comprenant des premier et second niveaux de métallisation interconnectés par une ou plusieurs voies d'interconnexion, le procédé comprenant la formation du premier niveau de métallisation par dépôt d'une couche (6) de séparation sur une couche (4) d'espacement, l'attaque de la couche (6) de séparation et de la couche (4) d'espacement pour y délimiter des régions de champ, le dépôt d'une première couche (10) de métal, la dissolution de la couche (6) de séparation pour enlever la première couche (10) de métal dans les régions de champ et pour laisser la première couche de métal dans une ou plusieurs régions de voies d'interconnexion, le dépôt d'une couche diélectrique (16), la mise à nu par exposition de la première couche (10) de métal à travers la couche diélectrique (16), le dépôt d'une seconde couche de métal et l'attaque de la seconde couche (18) de métal pour former le second niveau de métallisation, procédé caractérisé en ce qu'une couche (12) de protection contre une attaque chimique est déposée sur la première couche (10) de métal avant ladite étape de dissolution de la couche (6) de séparation, pour former le premier niveau de métallisation.

2. Procédé selon la revendication 1, caractérisé en ce que, entre ladite étape de dissolution de la couche (6) de séparation et ladite étape de dépôt d'une couche diélectrique (16), on procède au dépôt, sur la couche (4) d'espacement, d'une couche (14) de passivation.

3. Procédé selon la revendication 1 ou 2, caractérisé en ce que l'attaque de la couche (6) de séparation et de la couche (4) d'espacement est effectuée par attaque à l'aide d'un plasma.

4. Procédé selon la revendication 3, caractérisé en ce que l'attaque par un plasma est une attaque par plasma à l'oxygène.

5. Procédé selon l'une quelconque des revendications précédentes, caractérisé en ce que la couche (6) de séparation est déposée par projection par rotation ou filage.

6. Procédé selon l'une quelconque des revendications 2 à 5, caractérisé en ce que les première et seconde couches (10, 18) de métal sont déposées par pulvérisation à l'aide d'un magnétron.

7. Procédé selon l'une quelconque des revendications 2 à 6, caractérisé en ce que la couche (12) formant barrière de protection contre une attaque chimique est mise à nu ou exposée par attaque de la couche diélectrique (16) et contre-pulvérisation de la couche (14) de passivation.

8. Procédé selon l'une quelconque des revendications 2 à 6, caractérisé en ce que la couche (12) formant barrière de protection contre une attaque est mise à nu ou exposée par attaque de la couche diélectrique (16) et de la couche (14) de passivation.

9. Procédé selon l'une quelconque des revendications précédentes, caractérisé en ce que la couche (6) de séparation et la couche (4) d'espacement sont attaquées à travers une couche (8) de masquage en aluminium, sur laquelle sont délimitées les régions des champs.

10. Procédé selon l'une quelconque des revendications précédentes, caractérisé en ce que la couche (6) de séparation consiste en, ou comprend, une photoréserve.

11. Procédé selon l'une quelconque des revendications précédentes, caractérisé en ce que la couche (4) d'espacement est constituée par, ou comprend, du polyimide.

12. Procédé selon l'une quelconque des revendications précédentes, caractérisé en ce que la couche (12) formant barrière de protection contre une attaque est constituée par, ou comprend, du chrome.

13. Procédé selon l'une quelconque des revendications 2 à 12, caractérisé en ce que la couche diélectrique (16) est constituée par, ou comprend, du polyimide.

14. Procédé selon l'une quelconque des revendications 2 à 13, caractérisé en ce que la couche (14) de passivation est constituée par, ou comprend, du titane.

15. Procédé selon l'une quelconque des revendications 2 à 13, caractérisé en ce que la couche (14) de passivation est constituée par, ou comprend, du silicium.

$$m$$

$$V$$

$$s$$

NESTED VIA
PITCH = 2s + V + m

*Fig. 1.*    PITCH

$$m$$    $$W$$

$$V$$

$$g$$

NON-NESTED VIA
PITCH = m + W OR
PITCH = V + g
WHICHEVER IS
THE GREATER

*Fig. 2.*

1

FIG. 3.

FIG.4.